(19) Europäisches Patentamt
European Patent Office
Office européen des brevets

(11) **EP 3 208 628 B1**

(12) **EUROPÄISCHE PATENTSCHRIFT**

(45) Veröffentlichungstag und Bekanntmachung des Hinweises auf die Patenterteilung:
**17.10.2018 Patentblatt 2018/42**

(21) Anmeldenummer: **17156270.5**

(22) Anmeldetag: **15.02.2017**

(51) Int Cl.:
*G01R 33/36* [(2006.01)]       *G01R 33/44* [(2006.01)]
*G01F 1/716* [(2006.01)]       *G01R 33/563* [(2006.01)]
*G01N 24/08* [(2006.01)]       *G01R 33/30* [(2006.01)]

(54) **BESTIMMUNG EINER PULSDAUER T90 EINES 90°-PULSES BEI EINEM KERNMAGNETISCHEN MESSVERFAHREN**

DETERMINATION OF THE PULSE DURATION T90 OF A 90° PULSE IN A NUCLEAR MAGNETIC RESONANCE METHOD.

DÉTERMINATION DE LA DURÉE T90 D'UNE IMPULSION 90° DANS UN PROCÉDÉ DE RÉSONANCE MAGNÉTIQUE NUCLÉAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.02.2016 DE 102016103038**

(43) Veröffentlichungstag der Anmeldung:
**23.08.2017 Patentblatt 2017/34**

(73) Patentinhaber: **Krohne AG**
**4019 Basel (CH)**

(72) Erfinder: **Tromp, Rutger Reinout**
**3311 EM Dordrecht (NL)**

(74) Vertreter: **Gesthuysen Patent- und Rechtsanwälte Patentanwälte**
**Huyssenallee 100**
**45128 Essen (DE)**

(56) Entgegenhaltungen:
**US-A- 4 739 268      US-A1- 2011 001 474**

- **PAUL A KEIFER: "90° Pulse Width Calibrations: How to Read a Pulse Width Array", CONCEPTS IN MAGNETIC RESONANCE, Bd. 11, Nr. 3, 20. April 1999 (1999-04-20) , Seiten 165-180, XP055387960,**
- **Joël Mispelter ET AL: "Series Capacitive Matching" In: "NMR PROBEHEADS FOR BIOPHYSICAL AND BIOMEDICAL EXPERIMENTS", 2006, IMPERIAL COLLEGE PRESS, LONDON, XP055387998, ISBN: 978-1-86094-637-0 Seiten 48-53, * das ganze Dokument ***
- **PAVLINA J. M. ET AL.: "Conductivity Effects on RF Surface Coils used for MR-Guided HIFU of the Prostate", PROCEEDINGS OF THE JOINT ANNUAL MEETING ISMRM-ESMRMB, Nr. 3687, 28. April 2014 (2014-04-28), Seite 3687, XP040664715, Milan, Italy**

EP 3 208 628 B1

**Beschreibung**

Die Erfindung betrifft zum einen ein Verfahren zum Bestimmen einer Pulsdauer $T_{90}$ eines 90°-Pulses bei einem kernmagnetischen Messverfahren mit einer Schaltungsanordnung. Dabei weist die Schaltungsanordnung einen Signalgenerator zur Erzeugung des 90°-Pulses, eine Spule zur Übertragung des 90°-Pulses auf ein Medium, ein Koppelnetzwerk und eine Resonanzkreisfrequenz $\omega_0$ auf. Der Signalgenerator weist einen bekannten Generatorwirkwiderstand Rs auf. Die Spule weist eine Spulenimpedanz $Z_L$ mit einem Spulenwirkwiderstand $R_L$ und einem Spulenblindwiderstand $X_L$ gemäß $Z_L = R_L + jX_L$ auf. Aus der Patentschrift US 4,739,268 und aus der Abhandlung "Conductivity Effects on RF Surface Coils used for MR-Guided HIFU of the Prostate" von John M. Pavlina, Tetiana Dadakova, Ali Özen und Michael Bock sind ein Einfluss einer Leitfähigkeit eines Mediums auf eine Spulenimpedanz bekannt. Das Koppelnetzwerk weist einen Anpasskondensator mit einer einstellbaren Anpasskapazität $C_M$ und einen Einstellkondensator mit einer einstellbaren Einstellkapazität $C_T$ auf. Das Medium ist durch ein Magnetfeld für das kernmagnetische Messverfahren magnetisiert und weist eine Larmorpräzession mit einer Larmorkreisfrequenz $\omega_P$ auf.

Die Erfindung betrifft zum anderen ein kernmagnetisches Durchflussmessgerät für ein kernmagnetisches Messverfahren mit einer Schaltungsanordnung und einer Steuerung. Dabei weist die Schaltungsanordnung einen Signalgenerator zur Erzeugung eines 90°-Pulses, eine Spule zur Übertragung des 90°-Pulses auf ein Medium, ein Koppelnetzwerk und eine Resonanzkreisfrequenz $\omega_0$ auf. Der Signalgenerator weist einen bekannten Generatorwirkwiderstand $R_S$ auf. Die Spule weist eine Spulenimpedanz $Z_L$ mit einem Spulenwirkwiderstand $R_L$ und einem Spulenblindwiderstand $X_L$ gemäß $Z_L = R_L + jX_L$ auf. Das Koppelnetzwerk weist einen Anpasskondensator mit einer einstellbaren Anpasskapazität $C_M$ und einen Einstellkondensator mit einer einstellbaren Einstellkapazität $C_T$ auf. Das Medium ist durch ein Magnetfeld für das kernmagnetische Messverfahren magnetisiert und weist eine Larmorpräzession mit einer Larmorkreisfrequenz $\omega_P$ auf. Ein kernmagnetisches Durchflussmessgerät ist zum Beispiel aus der Offenlegungsschrift US 2011/0001474 A1 bekannt.

Die Schaltungsanordnung weist eine Resonanzkreisfrequenz $\omega_0$ auf, da sie als Schwingkreis ausgebildet ist.

Ein kernmagnetisches Messverfahren setzt voraus, dass ein Medium, an dem die kernmagnetischen Messungen des kernmagnetischen Messverfahrens vorgenommen werden sollen, Atomkerne enthält, die einen Kernspin und durch diesen auch ein magnetisches Moment besitzen. Der Kernspin eines Atomkerns wird als ein durch einen Vektor beschreibbarer Drehimpuls aufgefasst und entsprechend wird das magnetische Moment des Atomkerns durch einen Vektor beschrieben, der parallel zum Vektor des Drehpulses ausgerichtet ist. Der Vektor des magnetischen Moments des Atomkerns richtet sich bei Anwesenheit eines Magnetfelds tendenziell parallel zum Vektor des Magnetfelds am Ort des Atomkerns aus. Dabei präzessiert der Vektor des magnetischen Moments um den Vektor des Magnetfelds am Ort des Atomkerns. Diese Präzession wird als Larmorpräzession bezeichnet. Die Kreisfrequenz der Larmorpräzession wird als Larmorkreisfrequenz $\omega_P$ bezeichnet und ist das Produkt aus dem gyromagnetischen Verhältnis und dem Betrag der magnetischen Flussdichte des Magnetfelds am Ort des Atomkerns. Folglich ist die Larmorkreisfrequenz $\omega_P$ proportional zum Betrag der magnetischen Flussdichte am Ort des Atomkerns.

Kernmagnetische Messverfahren beruhen auf der Magnetisierung einer Mehrzahl von Atomkernen mit jeweils einem magnetischen Moment in einem Volumen eines Mediums durch ein Magnetfeld. Bei Abwesenheit eines Magnetfelds sind die einzelnen Ausrichtungen der Vektoren der magnetischen Momente statistisch gleichverteilt, weshalb das Medium in dem Volumen keine Magnetisierung aufweist. Die Anwesenheit eines Magnetfelds stört die statistische Gleichverteilung der einzelnen Ausrichtungen der Vektoren der magnetischen Momente, wodurch sich in dem Medium in dem Volumen eine Magnetisierung parallel zum Magnetfeld ausbildet. Unter Magnetisierungen werden im Allgemeinen makroskopische Magnetisierungen verstanden. Der zeitliche Verlauf des Prozesses der Ausrichtung der einzelnen Vektoren der magnetischen Momente in einem Magnetfeld ist durch die Spin-Gitter-Relaxationszeitkonstante charakterisiert und weist einen exponentiell abklingenden Verlauf auf. Die Werte der Spin-Gitter-Relaxationszeitkonstanten sind charakteristisch für verschiedene Substanzen, wobei Substanzen auch als Phasen bezeichnet werden.

Kernmagnetische Messverfahren bestimmen zum Beispiel den Durchfluss eines Mediums durch ein Messrohr eines kernmagnetischen Durchflussmessgeräts oder bei einem Medium mit mehreren Phasen, also mindestens zwei Phasen, die Anteile der einzelnen Phasen am Medium. Auch eine Kombination von kernmagnetischen Messverfahren ist möglich. Zum Beispiel bestimmt ein kernmagnetisches Messverfahren bei einem Medium mit mehreren Phasen sowohl die Anteile der einzelnen Phasen am Medium als auch den Durchfluss der einzelnen Phasen durch das Messrohr. Sowohl der Massestrom als auch der Volumenstrom eines Mediums werden als Durchfluss bezeichnet.

Bei einem Medium mit mehreren Phasen erfordert die Bestimmung der Anteile der einzelnen Phasen am Medium nicht nur, dass jede der Phasen Atomkerne mit magnetischen Momenten aufweist, damit die Phasen in einem Magnetfeld magnetisierbar sind, sondern auch, dass die einzelnen Phasen des Mediums unterschiedliche Spin-Gitter-Relaxationszeitkonstanten besitzen, damit die einzelnen Phasen voneinander unterscheidbar sind. Das aus Ölquellen geförderte Medium zum Beispiel besteht im Wesentlichen aus den flüssigen Phasen Rohöl und Salzwasser und der gasförmigen Phase Erdgas. Dabei enthalten alle Phasen Wasserstoffatomkerne. Da Wasserstoffatomkerne das größte gyromagnetische Verhältnis von allen Atomkernen und die einzelnen Phasen auch unterschiedliche Spin-Gitter-Relaxationszeitkonstanten besitzen, sind kernmagnetische Durchflussmessgeräte insbesondere zur Durchflussmessung des aus Ölquellen geförderten mehrphasigen Mediums geeignet. Zwar sind insbesondere Phasen mit Wasserstoffatomkernen für kernmagnetische Messverfahren geeignet, jedoch sind auch Phasen mit Atomkernen, die ein kleineres gyromagnetisches Verhältnis als Wasserstoffatomkerne besitzen, wie zum Beispiel Natriumatomkerne, für kernmagnetische Messverfahren geeignet.

Kernmagnetische Messverfahren umfassen für gewöhnlich auch kernmagnetische Messungen der Magnetisierung eines Mediums in einem Volumen nach einer bestimmten Einwirkdauer eines Magnetfelds. Eine solche kernmagnetische Messung erfordert die vorherige Drehung um einen Winkel von 90° der Vektoren der magnetischen Momente der Atomkerne des magnetisierten Mediums in dem Volumen in Bezug auf den Vektor des Magnetfelds. Die um einen Winkel von 90° gedrehten Vektoren der magnetischen Momente bewirken in einem Sensor ein Messsignal, das die Magnetisierung des Mediums in dem Volumen widerspiegelt. Ein solcher Sensor ist zum Beispiel eine Sensorspule, in welche die mit der Larmorkreisfrequenz $\omega_P$ präzessierenden magnetischen Momente eine Spannung als Messsignal induzieren. Die Stärke des Messsignals ist bei einer Drehung um einen Winkel von 90° maximal und nimmt demnach ab, wenn die Drehung nicht um einen Winkel von 90° erfolgt.

Eine Drehung der Vektoren der magnetischen Momente der Atomkerne des magnetisierten Mediums in dem Volumen in Bezug auf den Vektor des Magnetfelds erfolgt durch einen elektromagnetischen Puls, dem das magnetisierte Medium in dem Volumen ausgesetzt wird. Ein solcher Puls weist eine Kreisfrequenz $\omega_K$ auf, die der Larmorkreisfrequenz $\omega_P$ des Mediums entspricht, wodurch auf die magnetischen Momente der Atomkerne des Mediums in dem Volumen ein Drehmoment einwirkt, welches dann die Drehung bewirkt. Der Winkel der Drehung wird durch die Pulsdauer des Pulses bestimmt. Die Pulsdauer ist dabei von der Periodendauer $T_K = 2\pi/\omega_K$ einer einzelnen elektromagnetischen Schwingung eines Pulses zu unterscheiden. Ein elektromagnetischer Puls, der eine Drehung um einen Winkel von 90° bewirkt, wird als 90°-Puls und die Pulsdauer als $T_{90}$ bezeichnet. Die Pulsdauer $T_{90}$ ist dabei insbesondere vom Medium abhängig. Ein 90°-Puls weist genau eine einzige Pulsdauer $T_{90}$ auf.

Aus dem Stand der Technik ist bekannt, die für ein gegebenes Medium erforderliche Pulsdauer $T_{90}$ zu bestimmen, indem in einem Volumen des Mediums mit einer konstanten Magnetisierung eine Messreihe von kernmagnetischen Messungen der Magnetisierung bei unterschiedlichen Pulsdauern durchgeführt wird. Ein Verfahren zur Bestimmung der erforderlichen Pulsdauer $T_{90}$ wird zum Beispiel in der Abhandlung "90° Puls Width Calibrations: How to Read a Pulse Width Array" von Paul A. Keifer besprochen. Die Pulsdauer, die eine Drehung der magnetischen Momente um einen Winkel bewirkt, der einem Winkel von 90° am nächsten kommt, ist die Pulsdauer, bei der das stärkste Messsignal der Messreihe gemessen wird. Diese Pulsdauer wird der für eine Drehung um einen Winkel von 90° einzustellenden Pulsdauer $T_{90}$ zugewiesen.

Der Stand der Technik weist insbesondere den Nachteil eines hohen Zeitbedarfs für die Durchführung der Messreihe auf.

Der Erfindung liegt daher die Aufgabe zugrunde, ein Verfahren zum Bestimmen einer Pulsdauer $T_{90}$ eines 90°-Pulses bei einem kernmagnetischen Messverfahren sowie ein kernmagnetisches Durchflussmessgerät für ein kernmagnetisches Messverfahren anzugeben, bei dem der Zeitbedarf zum Bestimmen der Pulsdauer $T_{90}$ des 90°-Pulses im Vergleich zum Stand der Technik reduziert ist.

Die Erfindung bezieht sich gemäß einer ersten Lehre auf ein Verfahren zum Bestimmen einer Pulsdauer $T_{90}$ eines 90°-Pulses bei einem kernmagnetischen Messverfahren, bei dem die hergeleitete und aufgezeigte Aufgabe gelöst ist. Das erfindungsgemäße Verfahren ist zunächst und im Wesentlichen durch die folgenden Verfahrensschritte gekennzeichnet:

In einem ersten Verfahrensschritt werden die Anpasskapazität $C_M$ und die Einstellkapazität $C_T$ derart eingestellt, dass die Resonanzkreisfrequenz $\omega_0$ der Larmorkreisfrequenz $\omega_P$ entspricht und dass Leistungsanpassung zwischen dem Signalgenerator und der Spule vorliegt. In einem zweiten Verfahrensschritt wird der Spulenwirkwiderstand $R_L$ bestimmt. In einem dritten Verfahrensschritt wird die Pulsdauer $T_{90}$ aus einer Funktion des Spulenwirkwiderstands $R_L$ bestimmt.

Dabei ist die Resonanzkreisfrequenz $\omega_0$ durch die Schaltungstopologie der Schaltungsanordnung, den Generatorwirkwiderstand $R_S$, die Spulenimpedanz $Z_L$, die Anpasskapazität $C_M$ und die Einstellkapazität $C_T$ bestimmt. Der Generatorwirkwiderstand Rs repräsentiert im Allgemeinen den Leitungswellenwiderstand des Signalgenerators, der für gewöhnlich 50 Ω beträgt. Der Leitungswellenwiderstand wird auch als Nennimpedanz und im Englischen als "characteristic impedance" bezeichnet. Der Spulenblindwiderstand $X_L$ der Spulenimpedanz $Z_L$ weist eine induktive Komponente $L_L$ und eine kapazitive Komponente CL gemäß $X_L = \omega_0 L_L - 1/(\omega_0 C_L)$ bei der Resonanzkreisfrequenz $\omega_0$ auf. Die Leistungsanpassung bewirkt, dass ein Maximum der von dem Signalgenerator mit dem 90°-Puls abgegebenen Leistung in der Spule umgesetzt wird. Leistungsanpassung wird zum Beispiel durch Maximierung des Stroms erreicht, der von dem Signalgenerator in die Spule eingespeist wird. Die Einstellung der Resonanzkreisfrequenz $\omega_0$ auf die Larmorkreisfrequenz $\omega_P$ bewirkt, dass auch die Kreisfrequenz des 90°-Pulses der Larmorkreisfrequenz $\omega_P$ entspricht und der 90°-Puls ein Drehmoment auf die magnetischen Momente der Atomkerne des magnetisierten Mediums ausübt, wodurch die Vektoren der magnetischen Momente um einen Winkel von 90° in Bezug auf den Vektor des Magnetfelds gedreht werden.

Das Koppelnetzwerk weist einen Eingang und einen Ausgang auf, wobei der Eingang mit dem Signalgenerator und der Ausgang mit der Spule verbunden ist. Für gewöhnlich sind der Einstellkondensator und die Spule parallel geschaltet und sind der Signalgenerator, der Anpasskondensator und die Parallelschaltung, die aus dem Einstellkondensator und der Spule besteht, in Reihe geschaltet.

Der Spulenwirkwiderstand $R_L$ wird bestimmt, indem die Gleichungen für die Schaltungsanordnung gemäß den Kirchhoffschen Regeln nach dem Spulenwirkwiderstand $R_L$ aufgelöst werden. Die Gleichungen spiegeln die Schaltungstopologie wider.

Weiterhin ist das erfindungsgemäße Verfahren noch dadurch gekennzeichnet, dass die Funktion durch die Gleichung

$$R_L = A + BT_{90} - CT_{90}^3 + \frac{DT_{90}}{E + T_{90}^2}$$

beschrieben wird, wobei $A, B, C, D$ und $E$ abgespeicherte Konstanten sind. Die Pulsdauer $T_{90}$ wird aus der Gleichung bestimmt, indem die Gleichung nach der Pulsdauer $T_{90}$ aufgelöst wird. Die gespeicherten Konstanten $A, B, C, D$ und $E$ sind dabei reelle Zahlen.

Die beschriebene Funktion beruht auf mehreren Erkenntnissen:

Zunächst ist erkannt worden, dass der Spulenwirkwiderstand $R_L$ durch drei Komponenten, nämlich $R_r$, $R_i$, und $R_d$, gemäß $R_L = R_r + R_i + R_d$ beschrieben wird. Die erste Komponente $R_r$ repräsentiert den ohmschen Widerstand der elektrischen Leitungen, welche die Spule bilden. Die zweite Komponente $R_i$ beschreibt die durch den 90°-Puls aufgrund von Induktion im Medium bewirkte Erwärmung. Die dritte Komponente $R_d$ beschreibt die durch den 90°-Puls aufgrund von dielektrischer Kopplung mit dem Medium im Medium bewirkte Erwärmung.

Weiter ist erkannt worden, dass die drei Komponenten $R_r$, $R_i$, und $R_d$ bei den Lamorfrequenzen, die bei kernmagnetischen Messverfahren auftreten, gemäß

$$R_r + R_i + R_d = A' + B'\sigma - C'\sigma^3 + \frac{D'\sigma}{E' + \sigma^2}$$

beschrieben werden kann, so dass

$$R_L = A' + B'\sigma - C'\sigma^3 + \frac{D'\sigma}{E' + \sigma^2}$$

gilt. Dabei sind $A'$, $B'$, $C'$, $D'$ und $E'$ Konstanten und ist $\sigma$ die spezifische Leitfähigkeit des Mediums.

Darüber hinaus ist erkannt worden, dass die Pulsdauer $T_{90}$ proportional zur spezifischen Leitfähigkeit $\sigma$ des Mediums gemäß $\sigma = KT_{90}$ ist, wobei $K$ eine Konstante ist, so dass

$$R_L = A + BT_{90} - CT_{90}^3 + \frac{DT_{90}}{E + T_{90}^2}$$

gilt.

In einer Ausgestaltung des erfindungsgemäßen Verfahrens ist vorgesehen, dass der Spulenwirkwiderstand $R_L$ unter Verwendung des Generatorwirkwiderstands $R_S$, der Resonanzkreisfrequenz $\omega_0$, der Anpasskapazität $C_M$ und der Einstellkapazität $C_T$ bestimmt wird.

Es ist erkannt worden, dass der Spulenblindwiderstand $X_L$ der Spulenimpedanz $Z_L$ bei einer Vielzahl von Anwendungen nur geringe Änderungen aufweist. Deshalb wird in einer zur vorangehenden Ausgestaltung alternativen Ausgestaltung der Spulenblindwiderstand $X_L$ als konstant angenommen und der Spulenwirkwiderstand $R_L$ unter Verwendung des Generatorwirkwiderstands $R_S$, der Resonanzkreisfrequenz $\omega_0$ und entweder der Anpasskapazität $C_M$ oder der Einstellkapazität $C_T$ bestimmt. Das ist möglich, weil die Gleichungen für die Schaltungsanordnung gemäß den Kirchhoffschen Regeln durch die Annahme eines konstanten Spulenblindwiderstands $X_L$ überbestimmt sind. Deshalb kann zur Bestimmung des Spulenwirkwiderstands $R_L$ entweder die Anpasskapazität $C_M$ oder der Einstellkapazität $C_T$ verwendet werden. Diese Ausgestaltung bietet den Vorteil eines reduzierten Aufwands bei der Bestimmung des Spulenwirkwiderstands $R_L$.

In einer Weiterbildung der vorangehenden Ausgestaltung ist vorgesehen, dass der als konstant angenommene Spulenblindwiderstand $X_L$ unter Verwendung des Generatorwirkwiderstands $R_S$, der Resonanzkreisfrequenz $\omega_0$, der Anpasskapazität $C_M$ und der Einstellkapazität $C_T$ bestimmt wird. Für die Bestimmung werden die Gleichungen für die Schaltungsanordnung gemäß den Kirchhoffschen nach dem Spulenblindwiderstand $X_L$ aufgelöst. Der auf diese Weise bestimmte Spulenblindwiderstand $X_L$ wird dann in einem Verfahren gemäß der vorangehenden Ausgestaltung verwendet.

Bei Leistungsanpassung wird ein Maximum der von dem Signalgenerator abgegebenen Leistung in der Spule umgesetzt. Zur Einstellung der Leistungsanpassung wird ein Maß für Leistungsanpassung benötigt. Deshalb ist in einer weiteren Ausgestaltung vorgesehen, dass ein Maß für die Leistungsanpassung gebildet wird, indem die Leistung des 90°-Pulses am Signalgenerator und die an der Spule reflektierte Leistung des 90°-Pulses bestimmt werden und ein Verhältnis zwischen der reflektierten Leistung des 90°-Pulses und der Leistung des 90°-Pulses gebildet wird. Bei Leistungsanpassung wird keine Leistung an der Spule reflektiert.

Wenn die Bestimmung der Pulsdauer $T_{90}$ aus dem Spulenwirkwiderstand $R_L$ unter Verwendung der Konstanten A, B, C, D und E erfolgt, ist in einer weiteren Ausgestaltung vorgesehen, dass die Konstanten A, B, C, D und E aus einem Gleichungssystem bestimmt werden, wobei das Gleichungssystem gebildet wird, indem der Spulenwirkwiderstand $R_L$ bei mindestens fünf verschiedenen Pulsdauern $T_{90}$ des 90°-Pulses bestimmt wird und der jeweilige bestimmte Spulenwirkwiderstand $R_L$ und die jeweilige Pulsdauer $T_{90}$ jeweils in eine Gleichung gemäß

$$R_L = A + BT_{90} - CT_{90}^3 + \frac{DT_{90}}{E + T_{90}^2}$$

eingesetzt werden. Das Gleichungssystem weist fünf Unbekannte, nämlich die Konstanten A, B, C, D und E und die mindestens fünf Gleichungen auf, wobei in jeder der Gleichungen der Spulenwirkwiderstand $R_L$ und die Pulsdauer $T_{90}$ bekannt sind. Die bestimmten Konstanten A, B, C, D und E werden in einer Weiterbildung der vorangehenden Ausgestaltung abgespeichert und im erfindungsgemäßen Verfahren verwendet.

Es ist erkannt worden, dass die Larmorkreisfrequenz $\omega_P$ Schwankungen unterliegt und dass die Wirkung einer Schwankung der Larmorkreisfrequenz $\omega_P$ sowohl auf die Anpasskapazität $C_M$ als auch auf die Einstellkapazität $C_T$ durch eine Normierung kompensiert werden kann. Deshalb ist in einer weiteren Ausgestaltung vorgesehen, dass die Anpasskapazität $C_M$ und/oder die Einstellkapazität $C_T$ normiert werden/wird, indem ein Quotient aus der Resonanzkreisfrequenz $\omega_0$ als Dividend und einer Bezugsresonanzkreisfrequenz $\omega_0^n$ als Divisor gebildet wird und der Quotient mit der Anpasskapazität $C_M$ bzw. der Einstellkapazität $C_T$ multipliziert wird. Die Bestimmung der Normierung erfolgt zum Beispiel gemäß den Gleichungen

$$C_M^n = \left(\frac{\omega_0}{\omega_0^n}\right) C_M \quad \text{und} \quad C_T^n = \left(\frac{\omega_0}{\omega_0^n}\right) C_T \quad .$$

In den Gleichungen kennzeichnet der obere Index n die normierte Anpasskapazität $C_M$ und die normierte Einstellkapazität $C_T$. Die Bezugsresonanzkreisfrequenz $\omega_0^n$ ist eine Resonanzkreisfrequenz $\omega_0$.

In einer Weiterbildung der vorangehenden Ausgestaltung ist vorgesehen, dass das Magnetfeld durch Permanentmagneten erzeugt wird und die Bezugsresonanzkreisfrequenz $\omega_0^n$ bei einer Temperatur der Permanentmagneten bestimmt wird. Dieser Ausgestaltung liegen die Erkenntnisse zugrunde, dass zum einen die

Larmorkreisfrequenz $\omega_P$ insbesondere eine Funktion des Betrages der magnetischen Flussdichte des Magnetfelds ist und dass zum anderen die von den Permanentmagneten erzeugte magnetische Feldstärke und damit auch die magnetische Flussdichte im Medium eine Funktion der Temperatur ist. Mit dieser Ausgestaltung wird die Wirkung einer Schwankung der Temperatur der Permanentmagneten auf die Anpasskapazität $C_M$ und/oder die eingestellte Einstellkapazität $C_T$ kompensiert.

Die Erfindung bezieht sich gemäß einer zweiten Lehre auf ein kernmagnetisches Durchflussmessgerät für ein kernmagnetisches Messverfahren, bei dem die hergeleitete und aufgezeigte Aufgabe gelöst ist. Das erfindungsgemäße kernmagnetische Durchflussmessgerät ist zunächst und im Wesentlichen dadurch gekennzeichnet, dass die Steuerung eingerichtet ist, eine Pulsdauer $T_{90}$ des 90°-Pulses bei kernmagnetischen Messverfahren bei einem Medium zu bestimmen. Die Bestimmung erfolgt, indem die Steuerung die Anpasskapazität $C_M$ und die Einstellkapazität $C_T$ derart einstellt, dass die Resonanzkreisfrequenz $\omega_0$ der Larmorkreisfrequenz $\omega_P$ entspricht und dass Leistungsanpassung zwischen dem Signalgenerator und der Spule vorliegt, indem die Steuerung den Spulenwirkwiderstand $R_L$ bestimmt und indem die Steuerung die Pulsdauer $T_{90}$ aus einer Funktion des Spulenwirkwiderstands $R_L$ bestimmt. Dabei ist die Funktion durch

$$R_L = A + BT_{90} - CT_{90}^3 + \frac{DT_{90}}{E + T_{90}^2}$$

beschrieben, wobei A, B, C, D und E abgespeicherte Konstanten sind.

Die Ausführungen zu dem erfindungsgemäßen Verfahren gelten entsprechend auch für das erfindungsgemäße kernmagnetische Durchflussmessgerät und umgekehrt.

Eine Ausgestaltung des erfindungsgemäßen kernmagnetischen Durchflussmessgeräts sieht vor, dass die Steuerung zur Ausführung eines der zuvor beschriebenen erfindungsgemäßen Verfahren ausgebildet ist.

Im Einzelnen ist eine Vielzahl von Möglichkeiten gegeben, das erfindungsgemäße Verfahren und das erfindungsgemäße kernmagnetische Durchflussmessgerät auszugestalten und weiterzubilden. Dazu wird verwiesen sowohl auf die den Patentansprüchen 1 und 10 nachgeordneten Patentansprüche als auch auf die nachfolgende Beschreibung eines bevorzugten Ausführungsbeispiels in Verbindung mit der Zeichnung. In der Zeichnung zeigt

Fig. 1    ein Ausführungsbeispiel eines kernmagnetischen Durchflussmessgeräts und

Fig. 2    einen vereinfachten Stromlaufplan der Schaltungsanordnung des kernmagnetischen Durchflussmessgeräts aus Fig. 1.

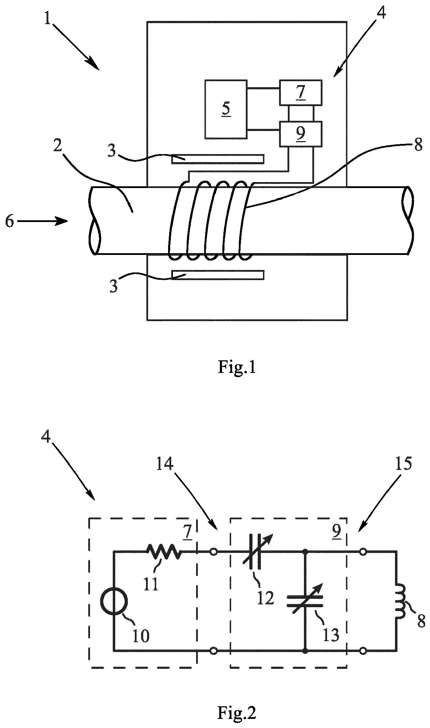

Fig. 1 zeigt ein Ausführungsbeispiel eines kernmagnetischen Durchflussmessgeräts 1 für kernmagnetische Messverfahren im Betrieb. In Fig. 1 sind das Messrohr 2, die Permanentmagneten 3, die Schaltungsanordnung 4 und die Steuerung 5 des kernmagnetischen Durchflussmessgeräts 1 dargestellt.

Das Messrohr 2 wird von dem Medium 6 durchströmt, wobei das Medium 6 mehrere Phasen aufweist. Die Permanentmagneten 3 erzeugen ein Magnetfeld, welches das Medium 6 in einem Volumen magnetisiert, so dass das Medium 6 eine Lamorpräzession mit der Larmorkreisfrequenz $\omega_P$ aufweist. Das kernmagnetische Durchflussmessgerät 1 ist zur Durchführung von kernmagnetischen Messverfahren ausgebildet, welche zum Beispiel die Durchflussgeschwindigkeiten der Phasen des Mediums 6 durch das Messrohr 2 und die Anteile der einzelnen Phasen am Medium 6 bestimmen.

Fig. 2 zeigt einen vereinfachten Stromlaufplan der wesentlichen Elemente der Schaltungsanordnung 4. Die Schaltungsanordnung 4 besteht aus dem Signalgenerator 7 zur Erzeugung eines 90°-Pulses, der Spule 8 zur Übertragung des 90°-Pulses auf das Medium 6 und dem Koppelnetzwerk 9.

Der Signalgenerator 7 weist im Wesentlichen die Signalquelle 10 und den Generatorwiderstand 11 auf, wobei der Generatorwiderstand 11 den gewählten und damit bekannten Generatorwirkwiderstand $R_S$ aufweist. Der Generatorwirkwiderstand Rs repräsentiert den Leitungswellenwiderstand des Signalgenerators 7 und beträgt in diesem Ausführungsbeispiel 50 Ω.

Die Spule 8 weist die Spulenimpedanz $Z_L$ mit dem Spulenwirkwiderstand $R_L$ und dem Spulenblindwiderstand $X_L$ gemäß $Z_L = R_L + jX_L$ auf.

Das Koppelnetzwerk 9 besteht in diesem Ausführungsbeispiel aus dem Anpasskondensator 12 mit der einstellbaren Anpasskapazität $C_M$ und dem Einstellkondensator 13 mit der Einstellkapazität $C_T$ und weist den Eingang 14 und den Ausgang 15 auf. Der Eingang 14 des Koppelnetzwerks 9 ist mit dem Signalgenerator 7 verbunden und der Ausgang 15 des Koppelnetzwerks 9 ist mit der Spule 8 verbunden. Dabei sind der Einstellkondensator 13 und die Spule 8 parallel geschaltet und sind die Signalquelle 10, der Generatorwiderstand 11, der Anpasskondensator 12 und die Parallelschaltung, die aus dem Einstellkondensator 13 und der Spule 8 besteht, in Reihe geschaltet.

Die Schaltungsanordnung 4 ist ein Schwingkreis, der die Resonanzkreisfrequenz $\omega_0$ aufweist, wobei die Resonanzkreisfrequenz $\omega_0$ durch die Topologie der Schaltungsanordnung 4, den Generatorwirkwiderstand Rs, die Anpasskapazität $C_M$, die Einstellkapazität $C_T$ und die Spulenimpedanz $Z_L$ bestimmt ist.

In der Schaltungsanordnung 5 sind der Generatorwiderstand 11, der Anpasskondensator 12, der Einstellkondensator 13 und die Spule 8 Vorrichtungen, wohingegen der Generatorwirkwiderstand Rs, die Anpasskapazität $C_M$, die Einstellkapazität $C_T$ und die Spulenimpedanz $Z_L$ Eigenschaften der vorgenannten Vorrichtungen sind.

Die Steuerung 5 bestimmt in diesem Ausführungsbeispiel eine Pulsdauer $T_{90}$ eines 90°-Pulses bei kernmagnetischen Messverfahren durch das Verfahren mit den folgenden Verfahrensschritten:

In einem ersten Verfahrensschritt werden die Anpasskapazität $C_M$ des Anpasskondensators 12 und die Einstellkapazität $C_T$ des Einstellkondensators 13 derart eingestellt, dass die Resonanzkreisfrequenz $\omega_0$ der Lamorkreisfrequenz $\omega_p$ des magnetisierten Mediums 6 entspricht und dass Leistungsanpassung zwischen dem Signalgenerator 7 und der Spule 8 vorliegt.

In einem zweiten Verfahrensschritt wird der Spulenwirkwiderstand $R_L$ bestimmt, indem die Gleichungen für die Schaltungsanordnung 4 gemäß den Kirchhoffschen Regeln nach dem Spulenwirkwiderstand $R_L$ aufgelöst werden und der Spulenwirkwiderstand $R_L$ unter Verwendung des Generatorwirkwiderstands $R_S$, der Resonanzkreisfrequenz $\omega_0$, der Anpasskapazität $C_M$ und der Einstellkapazität $C_T$ bestimmt wird.

In einem dritten Verfahrensschritt wird die Pulsdauer $T_{90}$ aus einer Funktion des Spulenwirkwiderstands $R_L$ bestimmt, die durch die Gleichung

$$R_L = A + BT_{90} - CT_{90}^3 + \frac{DT_{90}}{E + T_{90}^2}$$

beschrieben wird. In dieser sind *A, B, C, D* und E zuvor abgespeicherte Konstanten. Die Bestimmung erfolgt, indem die Gleichung nach der Pulsdauer $T_{90}$ aufgelöst wird und der bestimmte Spulenwirkwiderstand $R_L$ eingesetzt wird.

In diesem Ausführungsbeispiel des Verfahrens werden in einem zusätzlichen Verfahrensschritt die Anpasskapazität $C_M$ und die Einstellkapazität $C_T$ mit einer bei einer Temperatur der Permanentmagneten bestimmten Bezugsresonanzkreisfrequenz $\omega_0^n$ normiert, wodurch die Wirkung einer Schwankung der Temperatur der Permanentmagneten auf die Anpasskapazität $C_M$ und die Einstellkapazität $C_T$ kompensiert wird. Zur Normierung wird zunächst ein Quotient aus der Resonanzkreisfrequenz $\omega_0$ als Dividend und der Bezugsresonanzkreisfrequenz $\omega_0^n$ als Divisor gebildet. Der Quotient ist demnach $\omega_0 / \omega_0^n$. Dann wird der Quotient mit der Anpasskapazität $C_M$ bzw. der Einstellkapazität $C_T$ multipliziert. Damit ist die normierte Anpasskapazität

$$C_M^n = \left( \frac{\omega_0}{\omega_0^n} \right) C_M$$

und die normierte Einstellkapazität

$$C_T^n = \left(\frac{\omega_0}{\omega_0^n}\right) C_T \quad .$$

In den Gleichungen kennzeichnet der obere Index $n$ die normierte Anpasskapazität $C_M$ und die normierte Einstellkapazität $C_T$.

Die abgespeicherten Konstanten $A$, $B$, $C$, $D$ und $E$ sind bestimmt worden, indem unter Verwendung des zuvor beschriebenen Verfahrens ein Gleichungssystem gebildet worden ist. Das Gleichungssystem wurde in diesem Ausführungsbeispiel gebildet, indem der Spulenwirkwiderstand $R_L$ bei zehn verschiedenen Pulsdauern $T_{90}$ des 90°-Pulses bestimmt wurde und der jeweilige bestimmte Spulenwirkwiderstand $R_L$ und die jeweilige Pulsdauer $T_{90}$ jeweils in eine Gleichung gemäß

$$R_L = A + BT_{90} - CT_{90}^3 + \frac{DT_{90}}{E + T_{90}^2}$$

eingesetzt wurden. Das Gleichungssystem weist fünf Unbekannte, nämlich $A$, $B$, $C$, $D$ und $E$, und die zehn Gleichungen auf, wobei in jeder der zehn Gleichungen der Spulenwirkwiderstand $R_L$ und die Pulsdauer $T_{90}$ bekannt sind. Folglich ist das Gleichungssystem überbestimmt und die Konstanten $A$, $B$, $C$, $D$ und $E$ wurden aus dem Gleichungssystem bestimmt. Durch die Überbestimmung wurde die Genauigkeit der Bestimmung der Konstanten $A$, $B$, $C$, $D$ und $E$ gegenüber einer Bestimmung mit den mindestens erforderlichen fünf Gleichungen erhöht.

**Bezugszeichen**:

| | |
|---|---|
| 1 | Kernmagnetisches Durchflussmessgerät |
| 2 | Messrohr |
| 3 | Permanentmagneten |
| 4 | Schaltungsanordnung |
| 5 | Steuerung |
| 6 | Medium |
| 7 | Signalgenerator |
| 8 | Spule mit Spulenimpedanz $Z_L = R_L + jX_L$ |
| 9 | Koppelnetzwerk |
| 10 | Signalquelle |
| 11 | Generatorwiderstand mit Generatorwirkwiderstand $R_S$ |
| 12 | Anpasskondensator mit Anpasskapazität $C_M$ |
| 13 | Einstellkondensator mit Einstellkapazität $C_T$ |
| 14 | Eingang des Koppelnetzwerks |
| 15 | Ausgang des Koppelnetzwerks |

**Patentansprüche**

1. Verfahren zum Bestimmen einer Pulsdauer $T_{90}$ eines 90°-Pulses bei einem kernmagnetischen Messverfahren mit einer Schaltungsanordnung (4),
   wobei die Schaltungsanordnung (4) einen Signalgenerator (7) zur Erzeugung des 90°-Pulses, eine Spule (8) zur Übertragung des 90°-Pulses auf ein Medium (6), ein Koppelnetzwerk (9) und eine Resonanzkreisfrequenz $\omega_0$ aufweist,
   wobei der Signalgenerator (7) einen bekannten Generatorwirkwiderstand $R_S$ aufweist,
   wobei die Spule (8) eine Spulenimpedanz $Z_L$ mit einem Spulenwirkwiderstand $R_L$ und einem Spulenblindwiderstand $X_L$ gemäß $Z_L = R_L + jX_L$ aufweist,
   wobei das Koppelnetzwerk (9) einen Anpasskondensator (12) mit einer einstellbaren Anpasskapazität $C_M$ und einen Einstellkondensator (13) mit einer einstellbaren Einstellkapazität $C_T$ aufweist und
   wobei das Medium (6) für das kernmagnetische Messverfahren durch ein Magnetfeld magnetisiert ist und eine Larmorpräzession mit einer Larmorkreisfrequenz $\omega_P$ aufweist,
   **dadurch gekennzeichnet,**
   **dass** die Anpasskapazität $C_M$ und die Einstellkapazität $C_T$ derart eingestellt werden, dass die Resonanzkreisfrequenz $\omega_0$ der Larmorkreisfrequenz $\omega_P$ entspricht und dass Leistungsanpassung zwischen dem Signalgenerator (7) und der Spule (8) vorliegt,
   **dass** der Spulenwirkwiderstand $R_L$ bestimmt wird,
   **dass** die Pulsdauer $T_{90}$ aus einer Funktion des Spulenwirkwiderstands $R_L$ bestimmt wird und
   **dass** die Funktion durch

$$R_L = A + BT_{90} - CT_{90}^3 + \frac{DT_{90}}{E + T_{90}^2}$$

   beschrieben wird, wobei $A$, $B$, $C$, $D$ und $E$ abgespeicherte Konstanten sind.

2. Verfahren nach Anspruch 1, **dadurch gekennzeichnet, dass** der Spulenwirkwiderstand $R_L$ unter Verwendung des Generatorwirkwiderstands Rs, der Resonanzkreisfrequenz $\omega_0$, der Anpasskapazität $C_M$ und der Einststellkapazität $C_T$ bestimmt wird.

3. Verfahren nach Anspruch 1, **dadurch gekennzeichnet, dass** der Spulenblindwiderstand $X_L$ als konstant angenommen wird und der Spulenwirkwiderstand $R_L$ unter Verwendung des Generatorwirkwiderstands Rs, der Resonanzkreisfrequenz $\omega_0$ und entweder der Anpasskapazität $C_M$ oder der Einststellkapazität $C_T$ bestimmt wird.

4. Verfahren nach Anspruch 3, **dadurch gekennzeichnet, dass** der als konstant angenommene Spulenblindwiderstand $X_L$ unter Verwendung des Generatorwirkwiderstands $R_S$, der Resonanzkreisfrequenz $\omega_0$, der Anpasskapazität $C_M$ und der Einstellkapazität $C_T$ bestimmt wird.

5. Verfahren nach einem der Ansprüche 1 bis 4, **dadurch gekennzeichnet, dass** ein Maß für die Leistungsanpassung gebildet wird, indem die Leistung des 90°-Pulses am Signalgenerator und die an der Spule reflektierte Leistung des 90°-Pulses bestimmt werden und ein Verhältnis zwischen der reflektierten Leistung des 90°-Pulses und der Leistung des 90°-Pulses gebildet wird.

6. Verfahren nach einem der Ansprüche 1 bis 5, **dadurch gekennzeichnet, dass** die Konstanten A, B, C, D und E aus einem Gleichungssystem bestimmt werden, wobei das Gleichungssystem gebildet wird, indem der Spulenwirkwiderstand $R_L$ bei mindestens fünf verschiedenen Pulsdauern $T_{90}$ des 90°-Pulses bestimmt wird und der jeweilige bestimmte Spulenwirkwiderstand $R_L$ und die jeweilige Pulsdauer $T_{90}$ jeweils in eine Gleichung gemäß

$$R_L = A + BT_{90} - CT_{90}^3 + \frac{DT_{90}}{E + T_{90}^2}$$

eingesetzt werden.

7. Verfahren nach einem der Ansprüche 1 bis 6, **dadurch gekennzeichnet, dass** die Anpasskapazität $C_M$ und/oder die Einstellkapazität $C_T$ normiert werden/wird, indem ein Quotient aus der Resonanzkreisfrequenz $\omega_0$ als Dividend und einer Bezugsresonanzkreisfrequenz $\omega_0^n$ als Divisor gebildet wird und der Quotient mit der Anpasskapazität $C_M$ bzw. der Einstellkapazität $C_T$ multipliziert wird.

8. Verfahren nach Anspruch 7, **dadurch gekennzeichnet, dass** das Magnetfeld durch Permanentmagneten (3) erzeugt wird und die Bezugsresonanzkreisfrequenz $\omega_0^n$ bei einer Temperatur der Permanentmagneten (3) bestimmt wird.

9. Kernmagnetisches Durchflussmessgerät (1) für ein kernmagnetisches Messverfahren mit einer Schaltungsanordnung (4) und einer Steuerung (5), wobei die Schaltungsanordnung (4) einen Signalgenerator (7) zur Erzeugung eines 90°-Pulses, eine Spule (8) zur Übertragung des 90°-Pulses auf ein Medium (6), ein Koppelnetzwerk (9) und eine Resonanzkreisfrequenz $\omega_0$ aufweist, wobei der Signalgenerator (7) einen bekannten Generatorwirkwiderstand $R_S$ aufweist, wobei die Spule (8) eine Spulenimpedanz $Z_L$ mit einem Spulenwirkwiderstand $R_L$ und einem Spulenblindwiderstand $X_L$ gemäß $Z_L = R_L + jX_L$ aufweist, wobei das Koppelnetzwerk (9) einen Anpasskondensator (12) mit einer einstellbaren Anpasskapazität $C_M$ und einen Einstellkondensator (13) mit einer einstellbaren Einstellkapazität $C_T$ aufweist und wobei das Medium (6) für das kernmagnetische Messverfahren durch ein Magnetfeld magnetisiert ist und eine Larmorpräzession mit einer Larmorkreisfrequenz $\omega_P$ aufweist,
**dadurch gekennzeichnet,**
**dass** die Steuerung (5) eingerichtet ist, eine Pulsdauer $T_{90}$ des 90°-Pulses bei dem Medium zu bestimmen,
indem die Steuerung (5) die Anpasskapazität $C_M$ und die Einstellkapazität $C_T$ derart einstellt, dass die Resonanzkreisfrequenz $\omega_0$ der Larmorkreisfrequenz $\omega_P$ entspricht und dass Leistungsanpassung zwischen dem Signalgenerator (7) und der Spule (8) vorliegt,
indem die Steuerung (5) den Spulenwirkwiderstand $R_L$ bestimmt und
indem die Steuerung (5) die Pulsdauer $T_{90}$ aus einer Funktion des Spulenwirkwiderstands $R_L$ bestimmt, wobei die Funktion durch

$$R_L = A + BT_{90} - CT_{90}^3 + \frac{DT_{90}}{E + T_{90}^2}$$

beschrieben ist und wobei A, B, C, D und E abgespeicherte Konstanten sind.

10. Kernmagnetisches Durchflussmessgerät (1) nach Anspruch 9, **dadurch gekennzeichnet, dass** die Steuerung (5) zur Ausführung eines Verfahrens nach einem der Ansprüche 2 bis 8 ausgebildet ist.

**Claims**

1. Method for determining a pulse duration $T_{90}$ of a 90° pulse in a nuclear magnetic measuring method with a circuit arrangement (4),
wherein the circuit arrangement (4) has a signal generator (7) for generating the 90° pulse, a coil (8) for transmitting the 90° pulse to a medium (6), a coupling circuit (9) and an angular resonance frequency $\omega_0$,
wherein the signal generator (7) has a known generator resistance Rs, wherein the coil (8) has a coil impedance $Z_L$ with a coil resistance $R_L$ and a coil reactance $X_L$ according to $Z_L = R_L + jX_L$, wherein the coupling circuit (9) has a matching capacitor (12) having an adjustable matching capacitance $C_M$ and a tuning capacitor (13) having an adjustable tuning capacitance $C_T$, and
wherein, for the nuclear magnetic measuring method, the medium (6) is magnetized by a magnetic field and has a Larmor precession having an angular Lar-

mor frequency $\omega_P$,
**characterized in**
**that** the matching capacitance $C_M$ and the tuning capacitance $C_T$ are set so that the angular resonance frequency $\omega_0$ corresponds to the angular Larmor frequency $\omega_P$ and that power matching is present between the signal generator (7) and the coil (8),
**that** the coil resistance $R_L$ is determined,
**that** the pulse duration $T_{90}$ is determined as a function of the coil resistance $R_L$, and
**that** the function is described by

$$R_L = A + BT_{90} - CT_{90}^3 + \frac{DT_{90}}{E + T_{90}^2}$$

wherein $A, B, C, D$ and $E$ are stored constants.

2. Method according to claim 1, **characterized in that** the coil resistance $R_L$ is determined using the generator resistance $R_S$, the angular resonance frequency $\omega_0$, the matching capacitance $C_M$ and the tuning capacitance $C_T$.

3. Method according to claim 1, **characterized in that** the coil reactance $X_L$ is assumed to be constant and the coil resistance $R_L$ is determined using the generator resistance $R_S$, the angular resonance frequency $\omega_0$, and either the matching capacitance $C_M$ or the tuning capacitance $C_T$.

4. Method according to claim 3, **characterized in that** the coil reactance $X_L$ assumed to be constant is determined using the generator resistance $R_S$, the angular resonance frequency $\omega_0$, the matching capacitance $C_M$ and the tuning capacitance $C_T$.

5. Method according to any one of claims 1 to 4, **characterized in that** a measure is composed for power matching **in that** the power of the 90° pulse at the signal generator and the power of the 90° pulse reflected at the coil are determined and a ratio between the reflected power of the 90° pulse and the power of the 90° pulse is determined.

6. Method according to any one of claims 1 to 5, **characterized in that** the constants $A, B, C, D$ and $E$ are determined from a system of equations, wherein the system of equations is formed **in that** the resistance $R_L$ is determined for at least five different pulse durations $T_{90}$ of the 90° pulse and the respective resistance $R_L$ and the respective pulse duration $T_{90}$ are each applied to an equation according to

$$R_L = A + BT_{90} - CT_{90}^3 + \frac{DT_{90}}{E + T_{90}^2}.$$

7. Method according to any one of claims 1 to 6, **characterized in that** the matching capacitance $C_M$ and/or the tuning capacitance $C_T$ is/are scaled **in that** a quotient is formed of the angular resonance frequency $\omega_0$ as dividend and a reference angular resonance frequency $\omega_0^n$ as divisor and the quotient is multiplied by the matching capacitance $C_M$ or, respectively, the tuning capacitance $C_T$.

8. Method according to claim 7, **characterized in that** the magnetic field is generated using permanent magnets (3) and the reference angular resonance frequency $\omega_0^n$ is determined at one temperature of the permanent magnets (3).

9. Nuclear magnetic flowmeter (1) for a nuclear magnetic measuring method having a circuit arrangement (4) and a control unit (5),
wherein the circuit arrangement (4) has a signal generator (7) for generating a 90° pulse, a coil (8) for transmitting the 90° pulse to a medium, a coupling circuit (9) and a angular resonance frequency $\omega_0$,
wherein the signal generator (7) has a known generator resistance $R_S$, wherein the coil (8) has a coil impedance $Z_L$ with a coil resistance $R_L$ and a coil reactance $X_L$ according to $Z_L = R_L + jX_L$, wherein the coupling circuit (9) has a matching capacitor (12) having an adjustable matching capacitance $C_M$ and a tuning capacitor (13) having an adjustable tuning capacitance $C_T$, and
wherein, for the nuclear magnetic measuring method, the medium (6) is magnetized by a magnetic field and has a Larmor precession having an angular Larmor frequency $\omega_P$,
**characterized in**
**that** the control unit (5) is set up to determine the pulse duration $T_{90}$ of a 90° pulse,
in that the control unit (5) sets the matching capacitance $C_M$ and the tuning capacitance $C_T$ such that the angular resonance frequency $\omega_0$ corresponds to the angular Larmor frequency $\omega_P$ and that power matching is present between the signal generator (7) and the coil (8),
in that the control unit (5) determines the coil resistance $R_L$, and
in that the control unit (5) determines the pulse duration $T_{90}$ as a function of the coil resistance $R_L$,
wherein the function is described by

$$R_L = A + BT_{90} - CT_{90}^3 + \frac{DT_{90}}{E + T_{90}^2}$$

and wherein $A, B, C, D$ and $E$ are stored constants.

10. Nuclear magnetic flowmeter (1) according to claim 9, **characterized in that** the control unit (5) is designed to carry out a method according to any one of claims 2 to 8.

**Revendications**

1. Procédé de détermination d'une durée d'impulsion $T_{90}$ d'une impulsion à 90° lors d'un procédé de mesure magnétique nucléaire avec un arrangement de circuit (4),

   l'arrangement de circuit (4) possédant un générateur de signaux (7) destiné à générer l'impulsion à 90°, une bobine (8) servant à transmettre l'impulsion à 90° à un fluide (6), un réseau de couplage (9) et une fréquence de circuit de résonance $\omega_0$,

   le générateur de signaux (7) possédant une résistance active de générateur $R_S$ connue,

   la bobine (8) possédant une impédance de bobine $Z_L$ avec une résistance active de bobine $R_L$ et une résistance réactive de bobine $X_L$ conformément à $Z_L = R_L + jX_L$, le réseau de couplage (9) possédant un condensateur d'adaptation (12) ayant une capacité d'adaptation $C_M$ réglable et un condensateur de réglage (13) ayant une capacité de réglage $C_T$ réglable et

   le fluide (6) pour le procédé de mesure magnétique nucléaire étant magnétisé par un champ magnétique et possédant une précession de Larmor ayant une fréquence de Larmor $\omega_P$,

   **caractérisé en ce**

   **que** la capacité d'adaptation $C_M$ et la capacité de réglage $C_T$ sont réglées de telle sorte que la fréquence de circuit de résonance $\omega_0$ correspond à la fréquence de Larmor $\omega_P$ et qu'il existe une adaptation de puissance entre le générateur de signaux (7) et la bobine (8),

   **que** la résistance active de bobine $R_L$ est déterminée,

   **que** la durée d'impulsion $T_{90}$ est déterminée à partir d'une fonction de la résistance active de bobine $R_L$ et que la fonction est décrite par

   $$R_L = A + BT_{90} - CT_{90}^3 + \frac{DT_{90}}{E + T_{90}^2},$$

   où A, B, C, D et E sont des constantes mémorisées.

2. Procédé selon la revendication 1, **caractérisé en ce que** la résistance active de bobine $R_L$ est déterminée en utilisant la résistance active de générateur $R_S$, la fréquence de circuit de résonance $\omega_0$, la capacité d'adaptation $C_M$ et la capacité de réglage $C_T$.

3. Procédé selon la revendication 1, **caractérisé en ce que** la résistance réactive de bobine $X_L$ est supposée constante et la résistance active de bobine $R_L$

est déterminée en utilisant la résistance active de générateur $R_S$, la fréquence de circuit de résonance $\omega_0$ et soit la capacité d'adaptation $C_M$, soit la capacité de réglage $C_T$.

4. Procédé selon la revendication 3, **caractérisé en ce que** la résistance réactive de bobine $X_L$ supposée constante est déterminée en utilisant la résistance active de générateur $R_S$, la fréquence de circuit de résonance $\omega_0$, la capacité d'adaptation $C_M$ et la capacité de réglage $C_T$.

5. Procédé selon l'une des revendications 1 à 4, **caractérisé en ce qu'**une mesure pour l'adaptation de puissance est formée en déterminant la puissance de l'impulsion à 90° au niveau du générateur de signaux et la puissance de l'impulsion à 90° réfléchie au niveau de la bobine et un rapport entre la puissance réfléchie de l'impulsion à 90° et la puissance de l'impulsion à 90° est formé.

6. Procédé selon l'une des revendications 1 à 5, **caractérisé en ce que** les constantes A, B, C, D et E sont déterminées à partir d'un système d'équations, le système d'équations étant formé en déterminant la résistance active de bobine $R_L$ à au moins cinq durées d'impulsion $T_{90}$ de l'impulsion à 90° différentes et en utilisant la résistance active de bobine $R_L$ respective déterminée et la durée d'impulsion $T_{90}$ respective à chaque fois dans une équation selon

   $$R_L = A + BT_{90} - CT_{90}^3 + \frac{DT_{90}}{E + T_{90}^2}.$$

7. Procédé selon l'une des revendications 1 à 6, **caractérisé en ce que** la capacité d'adaptation $C_M$ et/ou la capacité de réglage $C_T$ est/sont normalisée(s) en formant un quotient à partir de la fréquence de circuit de résonance $\omega_0$ en tant que dividende et d'une fréquence de circuit de résonance de référence $\omega_0^n$ en tant que diviseur et en multipliant le quotient par la capacité d'adaptation $C_M$ ou la capacité de réglage $C_T$.

8. Procédé selon la revendication 7, **caractérisé en ce que** le champ magnétique est généré par des aimants permanents (3) et la fréquence de circuit de résonance de référence $\omega_0^n$ est déterminée à une température des aimants permanents (3).

9. Débitmètre magnétique nucléaire (1) pour un procédé de mesure magnétique nucléaire avec un arrangement de circuit (4) et une commande (5), l'arrangement de circuit (4) possédant un générateur de signaux (7) destiné à générer une impulsion à 90°, une bobine (8) servant à transmettre l'impulsion à 90° à un fluide (6), un réseau de couplage (9) et une fréquence de circuit de résonance $\omega_0$,

le générateur de signaux (7) possédant une résistance active de générateur $R_S$ connue,

la bobine (8) possédant une impédance de bobine $Z_L$ avec une résistance active de bobine $R_L$ et une résistance réactive de bobine $X_L$ conformément à $Z_L = R_L + jX_L$, le réseau de couplage (9) possédant un condensateur d'adaptation (12) ayant une capacité d'adaptation $C_M$ réglable et un condensateur de réglage (13) ayant une capacité de réglage $C_T$ réglable et

le fluide (6) pour le procédé de mesure magnétique nucléaire étant magnétisé par un champ magnétique et possédant une précession de Larmor ayant une fréquence de Larmor $\omega_P$,

**caractérisé en ce que** la commande (5) est conçue pour déterminer une durée d'impulsion $T_{90}$ de l'impulsion à 90° avec le fluide,

par le fait que la commande (5) règle la capacité d'adaptation $C_M$ et la capacité de réglage $C_T$ de telle sorte que la fréquence de circuit de résonance $\omega_0$ correspond à la fréquence de Larmor $\omega_P$ et qu'il existe une adaptation de puissance entre le générateur de signaux (7) et la bobine (8),

par le fait que la commande (5) détermine la résistance active de bobine $R_L$, et

par le fait que la commande (5) détermine la durée d'impulsion $T_{90}$ à partir d'une fonction de la résistance active de bobine $R_L$,

la fonction étant décrite par

$$R_L = A + BT_{90} - CT_{90}^3 + \frac{DT_{90}}{E + T_{90}^2},$$

et A, B, C, D et E étant des constantes mémorisées.

10. Débitmètre magnétique nucléaire (1) selon la revendication 9, **caractérisé en ce que** la commande (5) est configurée pour mettre en oeuvre un procédé selon l'une des revendications 2 à 8.

Fig.1

Fig.2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4739268 A
- US 20110001474 A1